# EUROPEAN PATENT SPECIFICATION

(11) **EP 0 825 652 B1**
(45) Date of publication and mention of the grant of the patent: **20.02.2002**
(21) Application number: 97111565.4
(22) Date of filing: 08.07.1997
(51) Int. Cl.: H01L 29/45, H01L 21/285, H01L 33/00

(54) **Ohmic electrode and method of forming the same**
Ohmsche Elektrode und Verfahren zu ihrer Herstellung
Electrode ohmique et son procédé de fabrication

(30) Priority: 24.07.1996 JP 21311796
(43) Date of publication of application: 25.02.1998
(73) Proprietor: SONY CORPORATION, Tokyo (JP)
(72) Inventor: Miyajima, Takao, Shinagawa-ku, Tokyo (JP)
(74) Representative: Müller, Frithjof E., Dipl.-Ing.

(56) References cited:
- JP-A- 7 254 732
- NAKAMURA S ET AL: "CANDELA-CLASS HIGH-BRIGHTNESS INGAN/AIGAN DOUBLE-HETEROSTRUCTURE BLUE-LIGHT-EMITTING DIODES" APPLIED PHYSICS LETTERS, vol. 64, no. 13, 28 March 1994, pages 1687-1689, XP000441256
- MOLNAR R J ET AL: "BLUE-VIOLET LIGHT EMITTING GALLIUM NITRIDE P-N JUNCTIONS GROWN BY ELECTRON CYCLOTRON RESONANCE-ASSISTED MOLECULAR BEAM EPITAXY" APPLIED PHYSICS LETTERS, vol. 66, no. 3, 16 January 1995, pages 268-270, XP000486024
- SMITH M A ET AL: "AN INVESTIGATION OF REFRACTORY METAL OHMIC CONTACTS TO GALLIUM NITRIDE" PROCEEDINGS OF THE FIRST SYMPOSIUM ON III-V NITRIDE MATERIALS AND PROCESSES, PROCEEDINGS OF III-V NITRIDE MATERIALS AND PROCESSES. (ISBN 1 56677 163 3), LOS ANGELES, CA, USA, 6-8 MAY 1996, 1996, PENNINGTON, NJ, USA, ELECTROCHEM. SOC, USA, pages 133-141, XP002077828
- KING D J ET AL: "Temperature behavior of Pt/Au ohmic contacts to p-GaN" GALLIUM NITRIDE AND RELATED MATERIALS II. SYMPOSIUM, GALLIUM NITRIDE AND RELATED MATERIALS II. SYMPOSIUM, SAN FRANCISCO, CA, USA, 1-4 APRIL 1997, 1997, PITTSBURGH, PA, USA, MATER. RES. SOC, USA, pages 421-426, XP002077829

## Description

### BACKGROUND OF THE INVENTION

### Field of the Invention

The present invention relates to an ohmic electrode structure for a p-type compound semiconductor layer containing at least one element selected from a group consisting of gallium, aluminum, boron and indium as a III group element, and nitrogen, and a method of forming the ohmic electrode structure.

### Description of the Related Art

Nitride III-V group semiconductors such as GaN, AlGaN, InGaN or BAlGaInN are considered to be promising as the material for forming a luminous element capable of emitting red or ultraviolet rays because of a reason that a band gap Eg can be varied from 1.8 eV to 6.2 eV. Further, attention is being paid also as a material for forming a Field Effect Transistor (FET) as an environment-proof element utilizing the property of a wide-gap semiconductor.

In these elements, the technique related to an ohmic electrode becomes very important in point of securing stabilized operation. For example, an ohmic electrode formed by laminating Ni and Au has been heretofore used as an ohmic electrode for a p-type GaN layer (see JP-A-6-275868).

Furtheron, JP-A-7254732 which belongs to the same patent family as US-A-5,696,389 discloses a light-emitting semiconductor device with an ohmic electrode structure comprising a p-type GaN cladding layer on which a p-side Pt/Ti/Pt/Au electrode is mounted.

In a conventional ohmic electrode, however, the value of contact specific resistance is approximately 1 x 10⁻² Ω cm², and has been fairly large as compared with the value of contact specific resistance in an ohmic electrode of another general semiconductor element (for example, approximately 1 x 10⁻⁵ Ω cm² in an ohmic electrode for a p-type GaAs layer). In addition, the conventional ohmic electrode had such a specific character that the value of contact specific resistance becomes larger when annealing is performed at a temperature of 400°C or higher. As a result, there has been such a problem that the value of contact specific resistance becomes large due to Joule heat generated at a contact portion between a semiconductor layer and a metal layer at the drive time of these elements or rise of ambient temperature and element characteristics are deteriorated.

### OBJECT AND SUMMARY OF THE INVENTION

It is conceivable that the value of the contact specific resistance in the ohmic electrode for a p-type GaN layer is larger as compared with a value of contact specific resistance in an ohmic electrode of another general semiconductor element as described above because of such a reason that a large barrier against holes is produced on the interface between the semiconductor layer and the metal layer since an energy difference Eᵥ - φ ᵥ (7.8 eV at RT) between the top of a valence band and vacuum level of GaN is larger as compared with a work function φ of a metal forming an electrode (for example, 5.2 eV for gold).

Further, it is conceivable that it is one of the causes for a value of contact specific resistance becoming larger by annealing at a high temperature in a conventional ohmic electrode that gold is diffused into a GaN layer by means of annealing.

The present invention has been made in view of such problems, and has for its object to provide an ohmic electrode structure in which the element can be made to operate stably for a long period by reducing the contact specific resistance and also increasing thermal stability thereof, and a method of forming the same.

An ohmic electrode structure according to the present invention is used for a p-type compound semiconductor layer containing at least one element selected from a group consisting of gallium, aluminum, boron, and indium as a III group element, and nitrogen, and is set out in claim 1.

A corresponding semiconductor element is set out in claim 13.

A method of forming an ohmic electrode structure according to the present invention is furthermore claimed in claim 6.

Specific embodiments are set out in the dependent claims.

In this ohmic electrode structure, wirings are connected to a p-type compound semiconductor layer through the electrode layer. When voltage is applied to the p-type compound semiconductor layer through these wirings and the electrode layer, holes are injected into the p-type compound semiconductor layer from the electrode layer.

In the ohmic electrode structure in accordance with the present invention, the barrier against the holes becomes smaller and the value of the contact specific resistance becomes small.

According to this method of forming an ohmic electrode structure, annealing is performed after forming a first layer, a second layer and a third layer one after another on a p-type compound semiconductor layer. In some cases, a reaction occurs in a part among the first layer, the second layer and the third layer by the annealing, and these layers become a transition metal containing layer, a platinum containing layer and a gold containing layer. At this time, the platinum containing layer prevents gold from diffusing toward the p-type compound semiconductor layer, and the transition metal containing layer also makes the platinum containing layer adhere closely to the p-type compound semiconductor layer.

### BRIEF DESCRIPTION OF DRAWINGS

Fig. 1 is a composition diagram showing an ohmic electrode structure according to an embodiment of the present invention;
Fig. 2 is a plan view of a specimen produced in a first embodiment of the present invention seen from an electrode layer side;
Fig. 3 is a sectional diagram taken along a line A-A showing the structure of the specimen shown in Fig. 2;
Fig. 4 is a characteristic diagram showing the relationship between a resistance value between electrodes and an annealing temperature in the embodiment of the present invention;
Fig. 5 is a relational diagram between a resistance value between electrodes and a distance between electrodes in the specimen shown in Fig. 2; and
Fig. 6 is a composition diagram showing a specimen produced in a fifth embodiment of the present invention.

### DESCRIPTION OF THE PREFERRED EMBODIMENTS

Embodiments of the present invention will be explained in detail hereinafter with reference to the drawings.

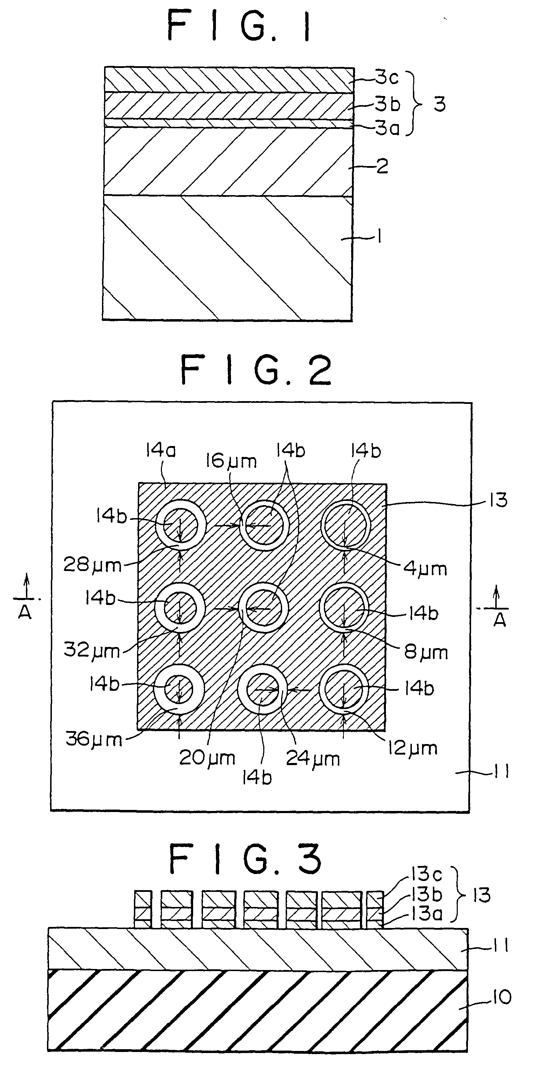

Fig. 1 shows an ohmic electrode structure according to one embodiment of the present invention. This ohmic electrode is for making ohmic contact with a p-type compound semiconductor layer 1 (such as a p-type GaN layer) containing at least one element selected from a group consisting of gallium (Ga), aluminum (Al), boron (B) and indium (In) as III group elements, and nitrogen (N). Besides, this p-type compound semiconductor layer 1 is formed on a substrate not shown by a Metal Organic Chemical Vapor Deposition (MOCVD) method.

This ohmic electrode is structured of a contact layer 2 formed on the p-type compound semiconductor layer 1 and an electrode layer 3 formed on this contact layer 2.

The contact layer 2 is formed of a p-type compound semiconductor which has been grown by an MBE method not using hydrogen gas (H₂) at time of growth. This p-type compound semiconductor contains at least one of gallium, aluminum, boron and indium as III group elements, and has the same structure elements as the p-type compound semiconductor layer 1. For example, when the p-type compound semiconductor layer 1 is formed of GaN added with magnesium (Mg) as p-type impurities, the contact layer 2 is also formed of GaN added with magnesium as p-type impurities.

However, since the contact layer 2 is formed by an MBE method using no hydrogen gas at the time of growth, the contact layer 2 does not contain hydrogen (H). The contact layer 2 is different in this point from that the p-type compound semiconductor layer 1 formed by an MOCVD method generally using hydrogen gas as carrier gas contains hydrogen. Since acceptors are compensated when hydrogen is introduced in p-type nitride III-V group semiconductors, when the semiconductor is formed by the MOCVD method, the resistance value is large immediately after formation, thus requiring to perform carrier activation processing such as electron beam radiation and thermal annealing (see H. Amano et al., Jpn. J. Appl. Phys. 28(1989) L2112., S. Nakamura et al., Jpn. J. Appl. Phys. 31(1992) L139 for carrier activation processing). Therefore, the p-type compound semiconductor layer 1 shows hole density of approximately 1x10¹⁷ to 1x10¹⁸ cm⁻³ for the first time by performing such carrier activation processing.

On the other hand, since hydrogen gas is not used in general in the MBE method, it is not required to perform carrier activation processing when the compound semiconductor layer is formed by the MBE method, but a value of approximately 1 x 10¹⁹ cm⁻³ which is higher than that when formed by the MOCVD method is also obtainable for the hole density (see M. S. Brandt et al., Appl. 1. Phys. Lett. 64 (1994) 2264). The contact layer 2 in the present embodiment also has hole density of approximately 1 x 10¹⁹ cm⁻³ which is higher as compared with that of the p-type compound semiconductor layer 1.

As described above, in the present embodiment, the contact specific resistance is made smaller by providing the contact layer 2 having hole density higher than that of the p-type compound semiconductor layer 1 between the p-type compound semiconductor layer 1 and the electrode layer 3. Namely, since the current flowing in the p-type compound semiconductor layer 1 from the electrode layer 3 is principally a tunnel current, by connecting the p-type compound semiconductor layer 1 with the electrode layer 3 through the contact layer 2 having high hole density, the barrier between the p-type compound semiconductor layer 1 and the electrode layer 3 is made smaller so as to make it easier to apply a tunnel current.

The electrode layer 3 contains at least gold, platinum (Pt) and a transition metal other than gold or platinum. For example, the electrode layer 3 is formed of a transition metal layer 3a containing at least one transition metal element other than gold or platinum, a layer 3b composed of platinum and a layer 3c composed of gold laminated one after another from the side of the p-type compound semiconductor layer 1 or, preferably, is formed of the structure resulting from annealing after the transition metal layer 3a, the platinum layer 3b and the gold layer 3c are laminated one after another.

Besides, it is conceived for the transition metal layer 3a, the platinum layer 3b and the gold layer 3c that a part of these respective layers reacts by applying annealing. Therefore, explanation is made herein assuming that respective layers after annealing are, although not shown, a transition metal containing layer containing at least one transition metal element other than gold or platinum, a layer containing platinum and a layer containing gold. Presumably, since the transition metal containing layer, the platinum containing layer and the gold containing layer have reacted to each other sometimes, it is not possible to separate them explicitly.

The transition metal layer 3a is formed of, for example, nickel, palladium (Pd), cobalt (Co), titanium (Ti) or molybdenum (Mo). Similarly, the transition metal containing layer contains, for example, nickel, palladium, cobalt, titanium or molybdenum. In the transition metal layer 3a or the transition metal containing layer, the contact layer 2 and the platinum layer 3b or the platinum containing layer are made to adhere very closely to each other so as to make the barrier against holes existing among them smaller utilizing such a specific character that the transition element such as nickel reacts to nitrogen easily thereby to form an interstitial nitride. Therefore, the thickness of the transition metal layer 3a is as thin as approximately 10 nm for instance as compared with the platinum layer 3b and the gold layer 3c.

Further, when nickel or palladium is used for the transition metal layer 3a or the transition metal containing layer, it is possible to make discontinuity of the contact layer 2 with the valence band smaller because the work function φ of nickel or palladium is comparatively large, which is preferable. Furthermore, since palladium has a property of adsorbing hydrogen, it is possible to adsorb hydrogen on the surface of the p-type compound semiconductor layer 1 so as to increase the hole density on the surface when the p-type compound semiconductor layer 1 and the electrode layer 3 are brought into direct contact with each other without providing the contact layer 2, which is preferable.

The platinum layer 3b or the platinum containing layer is for preventing gold from diffusing into the contact layer 2 by the rise of temperature utilizing the fact that platinum is a high melting-point metal. Further, since platinum has the largest work function φ (5.7 eV which is larger than the work function 5.2 eV of gold) among metals having high conductivity, discontinuity with the valence band of the contact layer 2 (viz., a p-type compound semiconductor) is minimum. Besides, the thickness of the platinum layer 3b is approximately 100 nm for instance.

The gold layer 3c or the gold containing layer is for connecting wirings not shown composed of gold for instance to the electrode layer 3 by bonding. Besides, the thickness of the gold layer 3c is approximately 200 nm for instance.

Such an ohmic electrode structure can be formed as described hereunder.

First, on the p-type compound semiconductor layer 1 formed by the MOCVD method and applied with appropriate carrier activation processing, a p-type compound semiconductor having the same structural elements as the p-type compound semiconductor layer 1 is grown by the MBE method. Besides, the growth by the MBE method is made without using hydrogen gas. With this, the contact layer 2 is formed.

Then, a transition metal layer 3a is formed on the contact layer 2 by vacuum-depositing a transition metal other than gold or platinum in the thickness of 10 nm for instance. Thereafter, a platinum layer 3b is formed on the transition metal layer 3a by vacuum-depositing platinum in the thickness of 100 nm for instance. Furthermore, a gold layer 3c is formed on the platinum layer 3b by vacuum-depositing gold in the thickness of 200 nm for instance. With this, an electrode layer 3 in which the transition metal layer 3a, the platinum layer 3b and the gold layer 3c are laminated one after another is formed.

Further, annealing may be applied further after forming these respective layers so that respective layers of the transition metal layer 3a, the platinum layer 3b and the gold layer 3c become a transition metal containing layer, a platinum containing layer and a gold containing layer in which a part of the above-mentioned respective layers have reacted.

An ohmic electrode structure thus formed functions as described hereunder.

In the ohmic electrode structure, wirings are connected to the p-type compound semiconductor layer 1 through the contact layer 2 and the electrode layer 3. When predetermined voltage is applied to the p-type compound semiconductor layer 1 through the wirings and the electrode layer 3, holes are injected into the p-type compound semiconductor layer 1 from the electrode layer 3 through the contact layer 2. Namely, the current flows from the electrode layer 3 to the p-type compound semiconductor layer 1.

Here, since the contact layer 2 has hole density higher than that of the p-type compound semiconductor layer 1 at the interface between the contact layer 2 and the electrode layer 3, a tunnel current is liable to flow therethrough. Further, since the contact layer 2 and the platinum layer 3b or the platinum containing layer are made to adhere very closely to each other by means of the transition metal layer 3a or the transition metal containing layer of the electrode layer 3, the barrier against holes has been made smaller. Furthermore, since the platinum layer 3b or the platinum containing layer is connected to the contact layer 2 through the thin transition metal layer 3a or the transition metal containing layer, discontinuity of the contact layer 2 with the valence band has been made smaller. Namely, the contact specific resistance has been made smaller.

In addition, since the platinum layer 3b or the platinum containing layer is inserted between the gold layer 3c or the gold containing layer and the contact layer 2, the gold is prevented from diffusing toward the contact layer 2 even when Joule heat is generated by application of voltage, thus increasing the temperature or rising the ambient temperature. Thus, even when the temperature rises, it is controlled that the contact specific resistance becomes higher.

As described above, according to an ohmic electrode structure related to the present embodiment, the contact layer 2, the transition metal layer 3a or the transition metal containing layer and the platinum layer 3b or the platinum containing layer are provided consecutively from the side of the p-type compound semiconductor layer 1. Therefore, it is possible to make the value of the contact specific resistance smaller. Further, the transition metal layer 3a or the transition metal containing layer and the platinum layer 3b or the platinum containing layer are provided one after another from the side of the p-type compound semiconductor layer 1. Thus, it is possible to increase thermal stability. Accordingly, it is possible to have the element operate stably for a long period.

Further, according to a method of forming an ohmic electrode structure according to the present embodiment, since annealing is performed after laminating the transition metal layer 3a, the platinum layer 3b and the gold layer 3c one after another, it is possible to have the platinum layer 3b adhere closely to the p-type compound semiconductor layer 1 by means of the transition metal layer 3a while preventing gold from diffusing toward the p-type compound semiconductor layer 1 by the platinum layer 3b. Thus, it is possible to realize an ohmic electrode structure according to the present embodiment.

Furthermore, the effects of the present invention will be described with reference to concrete embodiments.

### (The First Embodiment)

Fig. 2 shows a structure, seen from the side of an electrode layer 13, of a specimen produced in a first embodiment. Fig. 3 shows a sectional structure along a line A-A of the specimen shown in Fig. 2. Besides, the portion of the electrode layer 13 is shown with slashes in Fig. 2 for distinguishing between the electrode layer 13 and the p-type compound semiconductor layer 11.

In the present embodiment, first that in which a p-type compound semiconductor layer 11 is formed on an appropriate sapphire substrate 10 has been prepared. Besides, this p-type compound semiconductor layer 11 is formed by growing GaN added with magnesium as p-type impurities by the MOCVD growth, and carrier activation is performed by annealing at 800°C and for 10 minutes in a nitrogen gas atmosphere after growth is made. The hole density of the p-type compound semiconductor layer 11 is 4x10¹⁷ cm⁻³, and the thickness thereof is approximately 2 µ m.

Then, prior to forming the electrode layer 13, a photoresist film not shown has been applied onto the p- type compound semiconductor layer 11, and a pattern corresponding to the configuration of the electrode layer 13 shown in Fig. 3 has been formed by means of photolithography. This pattern is for forming a plurality of second electrodes 14 having different distances between electrodes for a first electrode 14a by removing a part of the electrode layer 13 to show a ring shape. Thereafter, the surface oxide film of the p-type compound semiconductor is removed with a mixed liquid of ammonium fluoride and hydrofluoric acid (HF), and cleaning has been performed thereafter with pure water.

Then, the p-type compound semiconductor is inserted into a deposition machine, and the electrode layer 13 in which the transition metal layer 13a, the platinum layer 13b and the gold layer 13c are laminated has been formed by depositing nickel in 10 nm, platinum in 100 nm and gold in 200 nm in succession in a vacuum of approximately 1x10⁻⁴ Pa. Thereafter, a photoresist film not shown is removed together with the transition metal layer 13a, the platinum layer 13b and the gold layer 13c formed thereon, and, as shown in Fig. 2 and Fig. 3, a specimen in which a first electrode 14a and a plurality of second electrodes 14b having distances among electrodes at 4 µm to 36 µm are formed has been produced.

After the specimen is produced as described above, resistance values among respective electrodes have been measured, respectively. Thereafter, the specimen was annealed in a nitrogen gas atmosphere, and variations of resistance values among respective electrodes have been measured, respectively. The measurement was made at the annealing temperature of 200°C, 300°C, 400°C, 500°C, 600°C, 700°C and 800°C, respectively. The annealing period of time was set at 30 seconds, respectively.

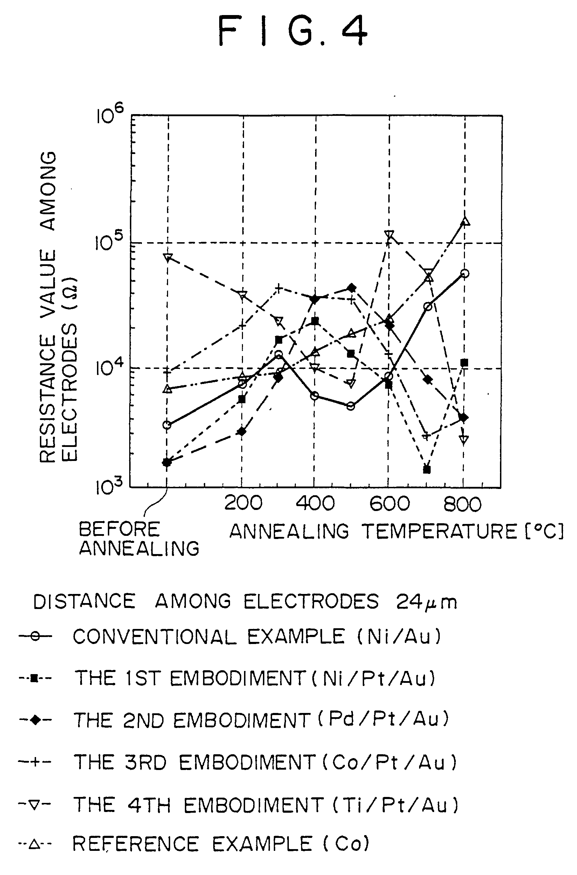

The results on those that have the distance among electrodes at 24 µm are shown in Fig. 4 while comparing with a conventional example. Besides, the conventional example means an example in which the platinum layer 13b in the present embodiment has been removed and Ni has been used as the transition metal layer 13a. Further, that in which only a cobalt layer has been formed on the p-type compound semiconductor layer 11 is also shown in Fig. 4 as a reference example.

Presumably, the resistance value here is obtained by adding the contact resistance value and the resistance value of the p-type compound semiconductor layer 11 to each other. However, since annealing is performed at the annealing temperature (800°C) in the case of carrier activation in the p-type compound semiconductor layer 11 or lower, it is conceived that the variation quantity of the resistance value of the p-type compound semiconductor layer 11 is small. Further, the change of the surface of the p-type compound semiconductor layer 11 caused by diffusion of a metal is considered as the change of the contact resistance value. Therefore, the change of the resistance value shown in Fig. 4 can be regarded in the same light with the change of the contact specific resistance.

As it is understood from Fig. 4, the resistance value before annealing was the smallest in the conventional example. Namely, it is conceivable that the contact specific resistance becomes larger by annealing in the conventional example. As against this, in the present embodiment, although the resistance value becomes larger temporarily by applying annealing, the resistance value has become the smallest by annealing at 700°C. Furthermore, the resistance value has become larger again when annealing is applied at 800°C. Further, when the resistance value before annealing in the conventional example and the resistance value before annealing in the present embodiment are compared with each other, it has been found that the resistance value in the present embodiment is smaller, and, when the smallest resistance value in the conventional example (before annealed) and the smallest resistance value in the present embodiment (annealed at 700°C) are compared with each other, it has also been found that the smallest resistance value in the present embodiment is smaller.

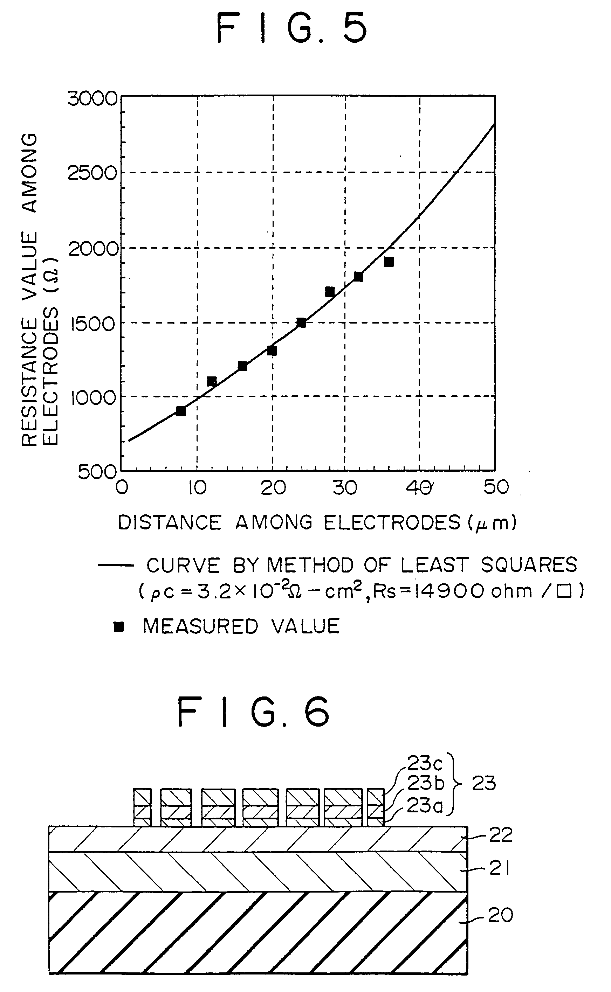

Further, when the value of the contact specific resistance when annealing is performed at 700°C was estimated, the value showed a comparatively small value at 3.2x10⁻² Ω cm² as shown in Fig. 5. Besides, as to the way of estimating the contact specific resistance, the method shown in "G.S. Marlow et al., Solid State Electronics 25(1982) 91" was used. Presumably, the sheet resistance value of the p-type compound semiconductor layer 11 at this time was 14 900 Ω / □ .

Therefore, according to the present embodiment, it has been found that the value of the contact specific resistance can be made smaller by the electrode layer 13 in which the transition metal layer 13a composed of nickel, the platinum layer 13b and the gold layer 13c are laminated one after another. In particular, it has been found that thermal stability can also be increased when annealing is performed at 700°C.

### (The Second Embodiment)

In a second embodiment, a specimen was produced similarly to the first embodiment except that the transition metal layer 13a was formed of palladium. Thereafter, the change of the resistance value caused by annealing was examined similarly to the first embodiment. Besides, in order to compare with the first embodiment, that which was cut out of the same wafer as the first embodiment was used for a p-type compound semiconductor layer 11 formed on a sapphire substrate 10.

The results obtained on those that has the distance among electrodes at 24 µm are shown in Fig. 4 similarly to the first embodiment. As it is comprehended from Fig. 4, in the present embodiment, the resistance value becomes smaller by annealing at 800°C, but the resistance value before annealing is performed has been the smallest. Further, when the resistance value before annealing is performed in a conventional example and the resistance value before annealing is performed in the present embodiment are compared with each other, it was found that the resistance value in the present embodiment was smaller.

Therefore, it has been realized that it is possible to make the value of the contact specific resistance smaller by means of an electrode layer 13 in which a transition metal layer 13a composed of palladium, a platinum layer 13b and a gold layer 13c are laminated one after another.

### (The Third Embodiment)

In a third embodiment, a specimen was produced in a similar manner as the first embodiment except that the transition metal layer 13a was formed of cobalt. Thereafter, the change of resistance value caused by annealing was examined similarly to the first embodiment. Besides, in order to compare with the first embodiment, that which has been cut out of the same wafer as the first embodiment was used for a p-type compound semiconductor layer formed on a sapphire substrate 10.

The results on those that have the distance among electrodes at 24 µm are shown in Fig. 4 similarly to the first embodiment. As it is realized from Fig. 4, although the resistance value before annealing was comparatively large, the resistance value becomes the smallest by means of annealing at 700°C in the present embodiment. Further, when the smallest resistance value (before annealing is applied) in the conventional example and the smallest value (annealed at 700°C) in the present embodiment were compared with each other, it was found that the resistance value in the present embodiment was smaller.

Thus, it has been comprehended that, according to the present embodiment, it is possible to make the value of the contact specific resistance smaller and also to increase the thermal stability by annealing at 700°C an electrode layer 13 in which the transition metal layer 13a composed of cobalt, the platinum layer 13b and the gold layer 13c are laminated one after another.

### (The Fourth Embodiment)

In a fourth embodiment, a specimen was produced in a similar manner as the first embodiment except that the transition metal layer 13a was formed of titanium. Thereafter, the change of the resistance value caused by annealing was examined similarly to the first embodiment. Besides, in order to compare with the first embodiment, that which was cut out of the same wafer as the first embodiment was used for a p-type compound semiconductor layer 11 formed on a sapphire substrate 10.

The results on those that have the distance among electrodes at 24 µm are shown in Fig. 4 similarly to the first embodiment. As it is realized from Fig. 4, although the resistance value before annealing is applied has been comparatively large, the resistance value became the smallest by means of annealing at 800°C in the present embodiment. Further, when the smallest resistance value (before annealing is applied) in the conventional example and the smallest resistance value (annealed at 800°C) in the present embodiment were compared with each other, it was found that the resistance value in the present embodiment was smaller.

Thus, it has been comprehended that, according to the present embodiment, it is possible to make the value of the contact specific resistance smaller and also to increase the thermal stability by annealing at 800°C an electrode layer 13 in which a transition metal layer 13a composed of titanium, a platinum layer 13b and a gold layer 13c are laminated one after another.

### (The Fifth Embodiment)

Fig. 6 shows a structure of a specimen produced in a fifth embodiment. In the present embodiment, a p- type compound semiconductor layer 21 formed on a sapphire substrate 20 was prepared first in a similar manner as the first embodiment. Then, an oxide film formed on the surface thereof was removed with a mixed liquid of ammonium fluoride and hydrofluoric acid, and, the p-type compound semiconductor layer 21 on the substrate 20 was inserted into a growth chamber of an MBE growth apparatus after cleaning with pure water and drying.

Thereafter, the substrate temperature was risen up to 850°C and the surface thereof was nitrided by nitrogen plasma, and a gallium beam, nitrogen plasma and a magnesium beam are radiated thereafter so as to grow GaN, thus forming a contact layer 22. At this time, nitrogen was excited by an Electron Cyclotron Resonance (ECR) cell or a Radio Frequency (RF) cell. Further, the cell temperature of gallium was set to 900°C, and the cell temperature of magnesium was set to 200°C to 500°C.

After forming the contact layer 22 in such a manner as described, a transition metal layer 23a composed of nickel, a platinum layer 23b and a gold layer 23c were laminated one after another in the similar manner as the first embodiment, thereby to form an electrode layer 23.

When the contact specific resistance was measured on the specimen produced as described above, it was found that the contact specific resistance was 10⁻³ Ω cm² or lower. Namely, it has been found that the value of the contact specific resistance could be made smaller by inserting the contact layer 22 between the p-type compound semiconductor layer 21 and the electrode layer 23.

The present invention has been described above citing embodiments. However, the present invention is not limited to these embodiments, but may be modified in various ways within the scope of the appended claims. For example, in the above-mentioned embodiment, the contact layer 2 was inserted between the p-type compound semiconductor layer 1 and the electrode layer 3, but it is not necessarily required to insert the contact layer 2 as seen from the first to the fourth embodiments.

Further, the transition metal layers 13a and 23a were formed of a simple substance such as nickel and palladium in the above-mentioned respective embodiments, but may be formed of an alloy with other metals.

As described above, according to the ohmic electrode structure of the present invention, an electrode layer containing gold, platinum and at least one transition metal element other than gold or platinum is provided. Therefore, it is possible to make the value of the contact specific resistance smaller and also to increase the thermal stability. Hence, such an effect that the corresponding semiconductor elements can be operated stably for a long period is produced.

Further, according to the method of forming the ohmic electrode structure of the present invention, since a step of forming a transition metal layer, a platinum layer and a gold layer one after another on a p-type compound semiconductor layer and a step of annealing thereafter are provided, it is possible to have the platinum layer adhere closely to the p-type compound semiconductor layer by the transition metal layer while preventing gold from diffusing toward the p-type compound semiconductor layer by means of the platinum layer. Thus, it is possible to realize an ohmic electrode structure according to the present invention.

## Claims

1. An ohmic electrode structure, comprising:
a p-type compound semiconductor layer (1; 11; 21; 2; 22) containing N and at least one element selected from a group consisting of Ga, Al, B and In; and
an electrode layer (3; 13; 23) containing at least Au, Pt and a transition metal element excluding Au and Pt on said p-type compound semiconductor layer (1; 11; 21; 2; 22).
**characterized in that**
said electrode layer (3; 13; 23) is composed of a first layer containing at least one transition metal element excluding Au and Pt on said p-type compound semiconductor layer (1; 11; 21; 2; 22), a second layer containing Pt on said first layer and a third layer containing Au on said second layer.

2. An ohmic electrode structure according to claim 1, wherein said electrode layer (3; 13; 23) is formed of a transition metal layer (3a; 13a; 23a) containing at least one transition metal element excluding Au and Pt on said p-type compound semiconductor layer (1; 11; 21; 2; 22), a Pt layer (3b; 13b; 23b) on said first layer and an Au layer (3c; 13c; 23c) on said second layer.

3. An ohmic electrode structure according to claim 1, wherein said first layer contains Pd.

4. An ohmic electrode structure according to claim 1, wherein said first layer contains Ni.

5. An ohmic electrode structure according to claim 1, wherein said p-type compound semiconductor layer (1; 21; 2; 22) comprises a contact layer (2; 22) composed of a p-type compound semiconductor containing N and at least one element selected from a group consisting of Ga, Al, B and In, said electrode layer (3; 23) being disposed on said contact layer (2; 22) and the hole density of said contact layer (2; 22) being higher than that of the portion (1; 21) of said p-type compound semiconductor layer not being the contact layer (2; 22).

6. A method of forming an ohmic electrode structure according to any one of claims 1 to 5, comprising the steps of:
forming a first layer containing at least one transition metal element excluding Au and Pt on a p- type compound semiconductor layer (1; 11; 21; 2; 22) containing N and at least one element selected from a group consisting of Ga, Al, B and In;
forming a second layer containing Pt on said first layer;
forming a third layer containing Au on said second layer; and
applying heat treatment to said first, second and third layers.

7. A method of forming an ohmic electrode structure according to claim 6, wherein said first layer contains Pd.

8. A method of forming an ohmic electrode structure according to claim 6, wherein said first layer contains Ni.

9. A method of forming an ohmic electrode structure according to claim 6, wherein said first layer is composed of Pd, said second layer is composed of Pt and said third layer is composed of Au.

10. A method of forming an ohmic electrode structure according to claim 6, wherein said first layer is composed of Ni, said second layer is composed of Pt, and said third layer is composed of Au.

11. A method of forming an ohmic electrode structure according to claim 6, wherein said first layer contains Ni, and the temperature of said heat treatment is set to 600°C to 800°C.

12. A method of forming an ohmic electrode structure according to claim 6, further comprising a step of forming a contact layer (2; 22) composed of a p-type compound semiconductor containing N and at least one element selected from a group consisting of Ga, Al, B and In comprised in said p-type compound semiconductor layer (1; 21; 2; 22) by means of molecular beam epitaxy, said first layer being formed on said contact layer (2; 22).

13. A semiconductor element having an ohmic electrode structure according to claim 1.

## Patentansprüche

1. Struktur einer Ohmschen Elektrode, mit:
- einer Verbindungshalbleiterschicht (1; 11; 21; 2; 22) vom p-Typ, die N und zumindest ein Element ausgewählt aus einer Gruppe bestehend aus Ga, Al, B und In enthält; und
- einer Elektrodenschicht (3; 13; 23) auf der Verbindungshalbleiterschicht (1; 11; 21; 2; 22) vom p-Typ, welche Elektrodenschicht zumindest Au, Pt und ein Übergangsmetallelement ausgenommen Au und Pt enthält, **dadurch gekennzeichnet, dass**
die Elektrodenschicht (3; 13; 23) aus einer ersten Schicht auf der Verbindungshalbleiterschicht (1; 11; 21; 2; 22) vom p-Typ, welche erste Schicht zumindest ein Übergangsmetallelement ausgenommen Au und Pt enthält, aus einer zweiten Schicht auf der ersten Schicht, welche zweite Schicht Pt enthält, und aus einer dritten Schicht auf der zweiten Schicht besteht, welche dritte Schicht Au enthält.

2. Struktur einer Ohmschen Elektrode nach Anspruch 1, bei der die Elektrodenschicht (3; 13; 23) auf der Verbindungshalbleiterschicht (1; 11; 21; 2; 22) vom p-Typ aus einer Übergangsmetallschicht (3a; 13a; 23a), die zumindest ein Übergangsmetallelement ausgenommen Au und Pt enthält, aus einer Pt-Schicht (3b; 13b; 23b) auf der ersten Schicht und aus einer Au-Schicht (3c; 13c; 23c) auf der zweiten Schicht gebildet ist.

3. Struktur einer Ohmschen Elektrode nach Anspruch 1, bei der die erste Schicht Pd enthält.

4. Struktur einer Ohmschen Elektrode nach Anspruch 1, bei der die erste Schicht Ni enthält.

5. Struktur einer Ohmschen Elektrode nach Anspruch 1, bei der die Verbindungshalbleiterschicht (1; 11; 21; 2; 22) vom p-Typ eine Kontaktschicht (2; 22) aufweist, die aus einem Verbindungshalbleiter vom p-Typ besteht, der N und zumindest ein Element ausgewählt aus einer Gruppe bestehend aus Ga, Al, B und In enthält, wobei die Elektrodenschicht (3; 13; 23) auf der Kontaktschicht (2; 22) angeordnet und die Löcherdichte der Kontaktschicht (2; 22) höher als die des Abschnitts (1; 21) der Verbindungshalbleiterschicht vom p-Typ ist, welche Verbindungshalbleiterschicht nicht die Kontaktschicht (2; 22) ist.

6. Verfahren zur Herstellung einer Struktur einer ohmschen Elektrode nach einem der Ansprüche 1 bis 5, mit den Schritten:
- Ausbilden einer ersten Schicht auf einer Verbindungshalbleiterschicht (1; 11; 21; 2; 22) vom p-Typ, die N und zumindest ein Element ausgewählt aus einer Gruppe bestehend aus Ga, Al, B und In enthält, welche erste Schicht zumindest ein Übergangsmetallelement ausgenommen Au und Pt enthält;
- Ausbilden einer zweiten Schicht auf der ersten Schicht, welche zweite Schicht Pt enthält;
- Ausbilden einer dritten Schicht auf der zweiten Schicht, welche dritte Schicht Au enthält; und
- Anwenden einer Wärmebehandlung auf die erste, zweite und dritte Schicht.

7. Verfahren zur Herstellung einer Struktur einer Ohmschen Elektrode nach Anspruch 6, worin die erste Schicht Pd enthält.

8. Verfahren zur Herstellung einer Struktur einer Ohmschen Elektrode nach Anspruch 6, worin die erste Schicht Ni enthält.

9. Verfahren zur Herstellung einer Struktur einer Ohmschen Elektrode nach Anspruch 6, worin die erste Schicht aus Pd, die zweite Schicht aus Pt und die dritte Schicht aus Au besteht.

10. Verfahren zur Herstellung einer Struktur einer Ohmschen Elektrode nach Anspruch 6, worin die erste Schicht aus Ni, die zweite Schicht aus Pt und die dritte Schicht aus Au besteht.

11. Verfahren zur Herstellung einer Struktur einer Ohmschen Elektrode nach Anspruch 6, worin die erste Schicht Ni enthält, und die Temperatur der Wärmebehandlung auf 600° C bis 800° C eingestellt ist.

12. Verfahren zur Herstellung einer Struktur einer Ohmschen Elektrode nach Anspruch 6, weiter mit einem Schritt zum Ausbilden einer Kontaktschicht (2; 22) mittels Molekularstrahlepitaxie, welche Kontaktschicht aus einem Verbindungshalbleiter vom p-Typ besteht, der N und zumindest ein Element ausgewählt aus einer Gruppe bestehend aus Ga, Al, B und In enthält, und welcher Verbindungshalbleiter in der Verbindungshalbleiterschicht (1; 21; 2; 22) vom p-Typ enthalten ist, wobei die erste Schicht auf der Kontaktschicht (2; 22) ausgebildet ist.

13. Halbleiterelement mit einer Struktur einer Ohmschen Elektrode nach Anspruch 1.

## Revendications

1. Structure d'électrode ohmique, comprenant :
une couche semi-conductrice (1 ; 11 ; 21 ; 2 ; 22) d'un composé de type p contenant N et au moins un élément choisi dans le groupe formé par Ga, Al, B et In, et
une couche (3 ; 13 ; 23) d'électrode contenant au moins Au, Pt et un élément métallique de transition à l'exclusion de Au et Pt sur la couche semi-conductrice (1 ; 11 ; 21 ; 2 ; 22) du composé de type p,
**caractérisée en ce que**
la couche (3 ; 13 ; 23) d'électrode est composée d'une première couche contenant au moins un élément métallique de transition à l'exclusion de Au et Pt sur la couche semi-conductrice (1 ; 11 ; 21 ; 2 ; 22) de composé de type p, une seconde couche contenant Pt sur la première couche et une troisième couche contenant Au sur la seconde couche.

2. Structure d'électrode ohmique selon la revendication 1, dans laquelle la couche (3 ; 13 ; 23) d'électrode est formée d'une couche d'un métal de transition (3a ; 13a ; 23a) contenant au moins un élément métallique de transition à l'exclusion de Au et Pt sur la couche semi-conductrice (1 ; 11 ; 21 ; 2 ; 22) de composé de type p, une couche de Pt (3b ; 13b ; 23b) sur la première couche et une couche de Au (3c ; 13c ; 23c) sur la seconde couche.

3. Structure d'électrode ohmique selon la revendication 1, dans laquelle la première couche contient Pd.

4. Structure d'électrode ohmique selon la revendication 1, dans laquelle la première couche contient Ni.

5. Structure d'électrode ohmique selon la revendication 1, dans laquelle la couche semi-conductrice (1 ; 21 ; 2 ; 22) comporte une couche de contact (2 ; 22) composée d'un semi-conducteur d'un composé de type p contenant N et au moins un élément sélectionné dans le groupe constitué par Ga, Al, B et In, la couche d'électrode (3 ; 23) étant disposée sur la couche de contact (2 ; 22) et la densité des trous de la couche de contact (2 ; 22) étant supérieure à celle de la partie (1 ; 21) de la couche semi-conductrice du composé de type p qui n'est pas la couche de contact (2 ; 22).

6. Procédé de formation d'une structure d'électrode ohmique selon l'une quelconque des revendications 1 à 5, comprenant les étapes suivantes :
la formation d'une première couche contenant au moins un élément métallique de transition à l'exclusion de Au et Pt sur une couche semi-conductrice (1 ; 11 ; 21 ; 2 ; 22) d'un composé de type p, contenant N et au moins un élément choisi dans le groupe formé par Ga, Al, B et In,
la formation d'une seconde couche contenant Pt sur la première couche,
la formation d'une troisième couche contenant Au sur la seconde couche, et
l'application d'un traitement thermique aux première, seconde et troisième couches.

7. Procédé de formation d'une structure d'électrode ohmique selon la revendication 6, dans lequel la première couche contient Pd.

8. Procédé de formation d'une structure d'électrode ohmique selon la revendication 6, dans lequel la première couche contient Ni

9. Procédé de formation d'une structure d'électrode ohmique selon la revendication 6, dans lequel la première couche est composée de Pd, la seconde couche est composée de Pt et la troisième couche est composée de Au.

10. Procédé de formation d'une structure d'électrode ohmique selon la revendication 6, dans lequel la première couche est composée de Ni, la seconde couche est composée de Pt et la troisième couche est composée de Au.

11. Procédé de formation d'une structure d'électrode ohmique selon la revendication 6, dans lequel la première couche contient Ni, et la température de traitement thermique est réglée entre 600 et 800 °C.

12. Procédé de formation d'une structure d'électrode ohmique selon la revendication 6, comprenant en outre une étape de formation d'une couche de contact (2 ; 22) composée d'un semi-conducteur d'un composé de type p contenant N et au moins un élément choisi dans le groupe formé par Ga, Al, B et In compris dans la couche semi-conductrice (1 ; 21 ; 2 ; 22) du composé de type p à l'aide d'une épitaxie par faisceau moléculaire, la première couche étant formée sur la couche de contact (2 ; 22).

13. Elément semi-conducteur ayant une structure d'électrode ohmique selon la revendication 1.
